# EUROPEAN PATENT APPLICATION

(11) **EP 4 546 974 A1**
(43) Date of publication of application: **30.04.2025**
(21) Application number: 24198189.3
(22) Date of filing: 03.09.2024
(51) Int. Cl.: H10D 30/66, H10D 62/10, H10D 62/13, H10D 62/17, H10D 62/832

(54) **POWER SEMICONDUCTOR DEVICES AND METHODS**

(30) Priority: 23.10.2023 KR 20230141832
(71) Applicant: LX Semicon Co., Ltd., Daejeon 34027 (KR)
(72) Inventor: PARK, Jin Ok, 34027 Yuseong-gu, Daejeon (KR); KANG, Nam Ju, 34027 Yuseong-gu, Daejeon (KR); SONG, Seung Wook, 34027 Yuseong-gu, Daejeon (KR); LEE, Doo Hyung, 34027 Yuseong-gu, Daejeon (KR); LEE, Chae Deok, 34027 Yuseong-gu, Daejeon (KR)
(74) Representative: Ter Meer Steinmeister & Partner

(57) **Abstract**

A power semiconductor device, a power semiconductor module including the same, a power converter, and methods of manufacture are provided. The power semiconductor device can include a substrate, a first conductivity type epitaxial layer disposed on the substrate, and a stepped well structure, where the width of a lower region of the stepped well structure is narrower than an upper region, but wider than an insulating or trench region.

## Description

### TECHNICAL FIELD

The embodiments relate to semiconductor devices and manufacture, and in particular, to a power semiconductor module and a power converter including the same.

### BACKGROUND

Power semiconductors are one of the key factors that determine the efficiency, speed, durability and reliability of power electronic systems.

With the recent development of the power electronics industry, as the previously used silicon (Si) power semiconductors reach their physical limits, research on WBG (Wide Bandgap) power semiconductors such as silicon carbide (SiC) and gallium nitride (GaN) to replace Si power semiconductors is being actively conducted.

WBG power semiconductor devices have bandgap energy about 3 times that of Si power semiconductor devices, resulting in low intrinsic carrier concentration, high dielectric breakdown field (about 4 to 20 times), and high thermal conductivity (about 3 to 13 times) and a large electron saturation rate (about 2 to 2.5 times).

Due to these characteristics, it can operate in a high-temperature, high-voltage environment and has high switching speed and low switching loss. Among them, a gallium nitride (GaN) power semiconductor device can be used for a low voltage system, and a silicon carbide (SiC) power semiconductor device can be used for a high voltage system.

A SiC MOSFET of power semiconductor device may be denoted as VDMOSFET (Vertical Diffused MOSFET) with a vertical diffused structure, or may be simply denoted as DMOSFET (Double Diffused MOSFET) with a double-diffused structure. Also, SiC MOSFET can be classified into a Planar MOSFET and a Trench MOSFET according to the channel direction.

However, there remains a need for improved power semiconductor devices, circuits or other modules incorporating power semiconductor devices, and methods of manufacture for power semiconductor devices.

For instance, the SiC VDMOSFET of the related art includes a shallow P-well structure for ease of fabrication in the line where withstand voltage can be secured. This shallow P-well structure has an effect of reducing R_{JFET} compared to Deep P-well structure. JFET refers to a pair of P-well region gaps located below the gate electrode. On the other hand, in the MOSFET device for power semiconductors having a high-power switching function, a robustness of the MOSFET device increases as a short circuit withstand time (SCWT) of the MOSFET device increases. The SCWT refers to a time that the MOSFET device can operate reliably when exposed to a short-circuit current.

However, conventional SiC VDMOSFET shows superiority in electrical characteristics compared to Si MOSFET due to high breakdown voltage and low Ron characteristics, but the SCWT of the conventional SiC VDMOSFET is relatively short so a robustness of the conventional SiC VDMOSFET is weak.

### SUMMARY

Embodiments described herein may address one or more of these challenges. According to some embodiments, a power semiconductor device, a power semiconductor module including the same, and a power converter that solve the problem that the SCWT is short are provided.

The object is solved by the features of the independent claims. Preferred embodiments are given in the dependent claims.

A power semiconductor device according to the embodiments may have a substrate and a stepped well.

The stepped well may have a first region, a second region, and an insulating layer in the first region.

The first region may have a width W1, the second region may have a width W3, and the width W1 may be greater than the width W3.

The second region may be located below the first region.

The insulating layer may be a buried insulating layer having a width W2, and the width W3 may be greater than the width W2.

Further, the embodiments may have a source region.

The source region may have a first portion and a second portion.

The first and second portions of the source region may be separated by the insulating layer.

At least the second region of the stepped well may be formed in a first conductivity type epitaxial layer on the substrate.

Both the first and second regions of the stepped well may have a second conductivity type and the source region may have the first conductivity type.

At least one of the substrate or the epitaxial layer may have silicon carbide (SiC).

A doping concentration of the second region of the stepped well may be less than or equal to the doping concentration of the first region of the stepped well.

Further, the embodiments may have a gate insulating layer disposed on the stepped well, a gate disposed on the gate insulating layer, an interlayer insulating layer disposed on the gate and a source electrode disposed on a source region of the device.

Further, the embodiments may have an ion implantation region disposed on at least one side of the stepped well.

A width of a contact region of the source electrode may be greater than a width of the ion implantation region.

A contact area of the source electrode may be in contact with the source region and the ion implantation region.

Further, the embodiments may have a plurality of stepped wells.

A first of the plurality of stepped wells may be separated from a second of the plurality of stepped wells by an ion implantation region.

A power converter according to the embodiments may have at least one power semiconductor device as described above.

A method for manufacturing a semiconductor device according to the embodiments may have the step of forming, on a substrate, a first epitaxial layer and a first well, wherein the first epitaxial layer has a first conductivity type and the first well has a second conductivity type, forming a source region in the first well, wherein the source region has the first conductivity type; forming an ion implantation region) in the first well and through the source region, wherein the ion implantation region has the second conductivity type and extends deeper into the first well than the source region, forming one or more junction field effect (JFET) regions on either side of the ion implantation region, forming a trench in the first well and forming a stepped-well structure comprising the first well and a second well below the first well.

Further, the embodiments may have a step of applying an insulating layer in the trench.

The forming the stepped-well structure may have a step of performing an ion implantation on a bottom of the trench to generate the second well.

The forming the stepped-well structure may have a step of performing a plurality of ion implementation steps and performing an activation process.

The performing a plurality of ion implementation steps may have a step of performing ion implantation with tilt and rotation of 90° on each of four side surfaces of the trench, respectively, and at least one ion implantation on the bottom surface.

A second conductivity type dopant concentration in the second well may be equal or less than that in the first well.

A width of the second well may be smaller than a width of the first well in the stepped-well structure.

The forming the trench may create a first portion of the source region and a second portion of the source region, the insulating layer may be applied between the first and second portions, and the first epitaxial layer in a region below the first well may not be exposed by formation of the trench.

According to the power semiconductor device, a power semiconductor module, and a power converter including the same of the embodiment, there are technical effects of improving SCWT characteristics while minimizing Ron increase by a stepped second conductivity type well designed to be deeply located.

For example, according to the embodiment, a stepped second conductivity type well can include a second conductivity type second-first well disposed on an upper side and a second conductivity type second-second well disposed on a lower side. In this case, a width of the second conductivity type second-second well disposed on the lower side can be controlled to be smaller than that of the second conductivity type second-first well disposed on the upper side. Accordingly, the JFET region can be designed to be further spaced apart in a depth direction of the substrate. Therefore, there is a special technical effect that can improve a loss of the Ron characteristic by preventing the increase of the R_{JFET} by maintaining a high withstand voltage characteristic.

Further, according to the embodiment, a physical distance between the channel and a bottom surface of the second conductive type well can be increased by the stepped second conductivity type well including deeply located second conductivity type second-second well such that concentration of the electric field in a channel can be reduced. So, there is a technical effect of reducing a channel resistance by improving a short channel effect.

In addition, according to the embodiment, the stepped second conductivity type well can include the second conductivity type second-first well and the second conductivity type second-second well disposed there below with a narrow width, there is a special technical effect that can enhance the SCWT characteristics by designing the second conductivity type second-second well to be deeply located.

Through this, the embodiment has a special technical effect capable of providing a power semiconductor device, a power semiconductor module including the same, and a power converter capable of increasing the robustness by enhancing the SCWT characteristics.

The technical effects of the embodiments are not limited to those described in this section, but include those that can be understood through the description of the invention.

### BRIEF DESCRIPTION OF THE DRAWINGS

The accompanying drawings, which are incorporated herein and form part of the specification, illustrate various, non-limiting embodiments of the present invention. In the drawings, like reference numbers indicate identical or functionally similar elements.
FIG. 1 illustrates a power converter according to embodiments.
FIG. 2 illustrates a cross-sectional view of a power semiconductor device of embodiments.
FIG. 3A, 3B illustrate cross-sectional views of a power semiconductor device of embodiments.
FIG. 4A illustrates a plan view of a power semiconductor device according to embodiments.
FIG. 4B illustrates a partial cross-sectional view of a power semiconductor device of embodiments.
FIGS. 5A to 5I illustrate cross-sectional views of a manufacturing process of a power semiconductor device according to embodiments.

### DETAILED DESCRIPTION

Hereinafter, embodiments are described in detail with reference to the drawings.

The suffixes "module" and "unit" for the elements used in the following description are simply given in consideration of ease of writing this specification, and do not themselves give a particularly important meaning or role. Accordingly, the "module" and "unit" can be used interchangeably.

Terms including ordinal numbers, such as first and second, can be used to describe various elements, but the elements are not limited by the terms. These terms are only used for the purpose of distinguishing one element from another.

Singular expressions include plural expressions unless the context clearly dictates otherwise.

In this application, terms such as "comprise", "have" or "include" are intended to designate that there is a feature, number, step, operation, component, part, or combination thereof described in the specification, and it is not precluded from being excluded one or other features, numbers, steps, operations, components, parts, or combinations thereof, or any combination thereof.

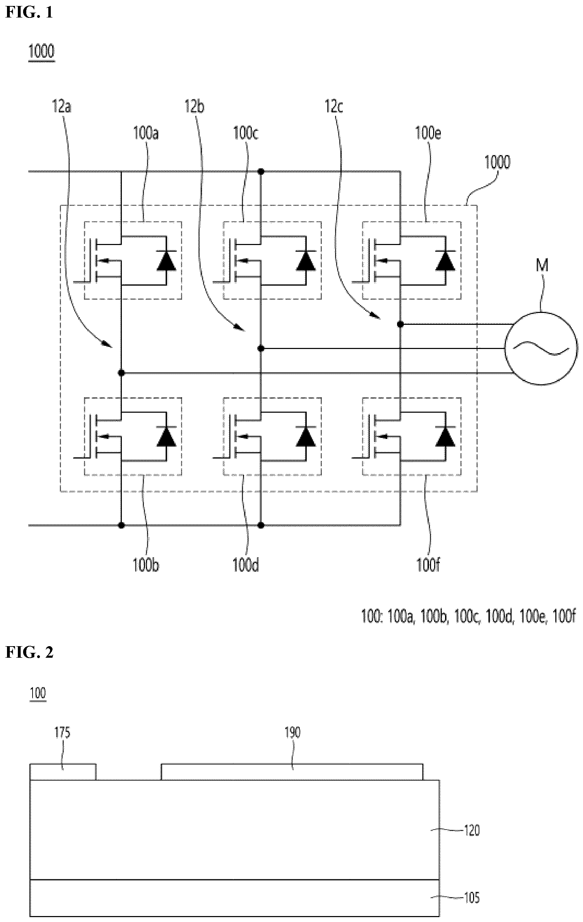

Referring now to FIG. 1, a power converter 1000 is provided according to one or more embodiments.

The power converter 1000 according to the embodiment can receive DC power from a battery or fuel cell, convert it into AC power, and supply AC power to a predetermined load. For example, the power converter 1000 according to the embodiment can include an inverter, which receives DC power from a battery, converts DC power into 3-phase AC power, and supplies 3-phase AC power to a motor M. In certain aspects, motor M can provide power to electric vehicles or fuel cell vehicles.

Referring now to FIG. 1, a power converter 1000 is provided according to one or more embodiments.

The power converter 1000 according to embodiments can include one or more power semiconductor devices 100. The power semiconductor device 100 can be, for example, a Metal Oxide Semiconductor Field Effect Transistor (MOSFET), but is not limited thereto. For instance, it could be an Insulated Gate Bipolar Transistor (IGBT) in some embodiments. According to embodiments, MOSFETs, such as SiC MOSFETS, can have various structures. Examples include a trench structure MOSFET, a vertical doubly implanted structure MOSFET (DIMOSFETs), or a lateral diffused structure MOSFET, etc.

In some embodiments, the power converter 1000 can include a plurality of power semiconductor devices 100a, 100b, 100c, 100d, 100e, and 100f. The power converter 1000 may also have a plurality of diodes (not shown). In certain aspects, each of the plurality of diodes can be internally incorporated in each of the power semiconductor devices 100a, 100b, 100c, 100d, 100e, and 100f in the form of an internal diode, but is not limited thereto, and can be disposed separately.

In the example of FIG. 1, DC power can be converted into AC power through on-off control of the plurality of power semiconductor devices 100a to 100f. For instance, in the power converter 1000 according to embodiments, the first power semiconductor device 100a can be turned on and the second power semiconductor device 100b can be turned off in a first time period of one cycle to supply positive polarity power to the motor M. In addition, in the second time period of one cycle, the first power semiconductor device 100a can be turned off and the second power semiconductor device 100b can be turned on to supply negative polarity power to the motor M.

A group of power semiconductor devices disposed in series in a high voltage line and a low voltage line of an input side can be referred to as an arm. For example, the first power semiconductor device 100a and the second power semiconductor device 100b can constitute a first arm, and the third power semiconductor device 100c and the fourth power semiconductor device 100d can constitute a second arm. And the fifth power semiconductor device 100e and the sixth power semiconductor device 100f can constitute a third arm.

In the arm, an upper side power semiconductor device and a lower side power semiconductor device can be controlled not to turn on at the same time. For example, in the first arm, the first power semiconductor device 100a and the second power semiconductor device 100b do not simultaneously turn on, but can turn on and off alternately.

In some embodiments, each of the power semiconductor devices 100a to 100f can receive high power in an off state. For example, when the second power semiconductor device 100b is turned off while the first power semiconductor device 100a is turned on, the input voltage can be applied to the second power semiconductor device 100b as it is. The voltage input to the second power semiconductor device 100b can be a relatively high voltage, and a withstand voltage of each power semiconductor device 100a to 100f can be designed to have a high level to withstand such a high voltage.

Additionally, and in certain aspects, each of the power semiconductor devices 100a to 100f can conduct a high current in a turn on state. The motor M can be driven with a relatively high current, and this high current can be supplied to the motor M through a power semiconductor that is turned on.

A high voltage applied to each of the power semiconductor devices 100a to 100f can cause a high switching loss. A high current conducting the power semiconductor devices 100a to 100f can cause a high conduction loss. In order to dissipate heat generated by such switching loss or conduction loss, the power semiconductor devices 100a to 100f can be packaged as a power semiconductor module including a heat dissipation means.

In some embodiments, the power semiconductor device 100 can be a silicon carbide (SiC) power semiconductor device. In certain aspects, it can operate in a high-temperature, high-voltage environment, and can have a high switching speed and low switching loss.

In some embodiments, the power converter 1000 according to the embodiment can include a plurality of power semiconductor modules.

For example, the plurality of power semiconductor devices 100a to 100f shown in FIG. 1 can be packaged into one power semiconductor module, or the power semiconductor devices constituting each arm can be packaged into one power semiconductor module.

As another example, the first power semiconductor device 100a, the second power semiconductor device 100b, the third power semiconductor device 100c, the fourth power semiconductor device 100d, and the fifth power semiconductor device 100e and the sixth power semiconductor device 100f shown in FIG. 1 can be packaged into one power semiconductor module.

In addition, there can be additional power semiconductor devices disposed in parallel with each of the power semiconductor devices 100a to 100f to increase a current capacity. In this case, the number of power semiconductor devices included in the power semiconductor module can be greater than six.

The power converter 1000 according to embodiments can include a diode-type power semiconductor device in addition to the transistor-type power semiconductor devices 100a to 100f. For example, a first diode (not shown) can be disposed in parallel with the first power semiconductor device 100a, and a second diode (not shown) can be disposed in parallel with the second power semiconductor device 100b. Also, these diodes can be packaged together in one power semiconductor module. In addition, the diode can be disposed in the form of an internal diode in each power semiconductor device.

In some embodiments, the power semiconductor devices constituting each arm can be packaged into one power semiconductor module. For example, the first power semiconductor device 100a and the second power semiconductor device 100b constituting the first arm can be packaged as a first power semiconductor module. The third power semiconductor device 100c and the fourth power semiconductor device 100d constituting the second arm can be packaged into a second power semiconductor module. And the fifth power semiconductor device 100e and the sixth power semiconductor device 100f constituting the third arm can be packaged into a third power semiconductor module.

In addition, there can be additional power semiconductor devices arranged in parallel with each power semiconductor device 100a to 100f to increase a current capacity. In this case, the number of power semiconductor devices included in each power semiconductor module can be more than two. Also, each arm can include a diode-type power semiconductor device (not shown) in addition to the transistor-type power semiconductor devices 100a to 100f, and these diodes can also be packaged together in one power semiconductor module. In addition, the diode can be disposed in a form of an internal diode in each power semiconductor device.

FIG. 2 illustrates a cross-sectional view of a power semiconductor device, such as device 100, according to embodiments. In certain aspects, this device may be used in a circuit or other module, such as a power converter 1000 as described in connection with FIG. 1.

The power semiconductor device 100, such as a MOSFET, according to embodiments can include a source electrode 190 disposed above a semiconductor epitaxial layer 120, a gate electrode 175, and a drain electrode 105 disposed below the semiconductor epitaxial layer 120.

In embodiments, the source electrode 190 or the gate electrode 175 can include an Al-based metal, and the drain electrode 105 can include Ti/Ni/Ag metal including a Ti layer, a Ni layer, or an Ag layer, or NiV/Ag, V(vanadium)/Ni/Ag, or the like, but is not limited thereto.

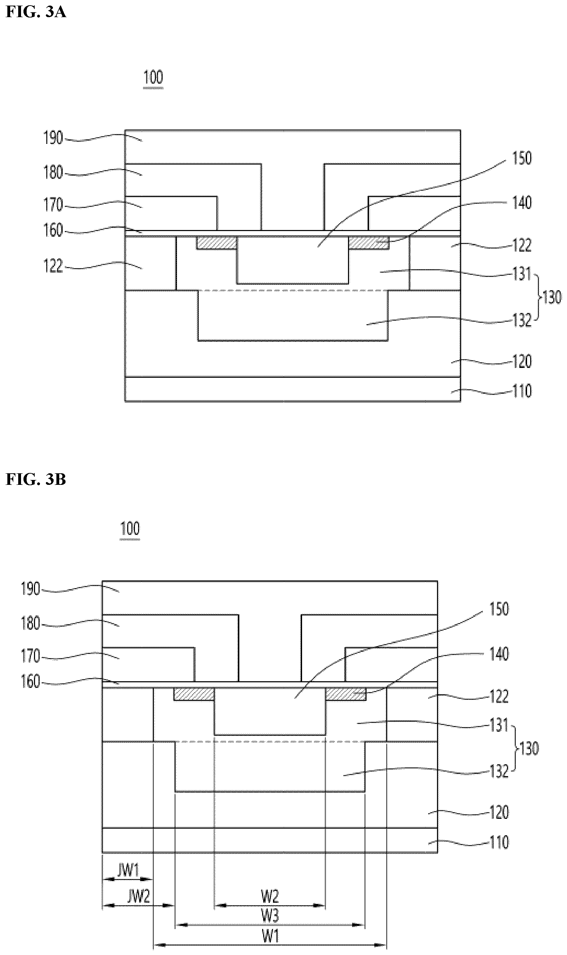

FIG. 3A is a cross-sectional view of a power semiconductor device 100 according to embodiments, and FIG. 3B is a detailed cross-sectional view of the power semiconductor device 100 according to the example shown in FIG. 3A.

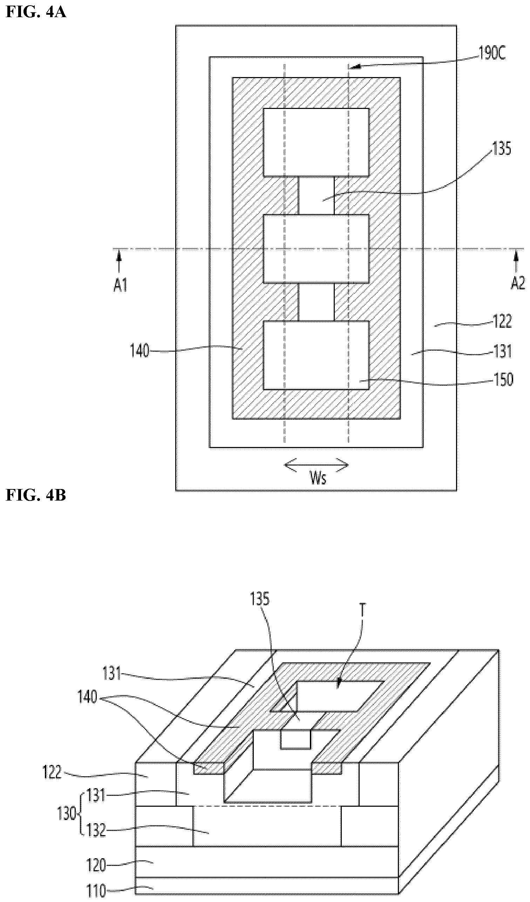

FIG. 4A is a plan view of a power semiconductor device 100 according to embodiments, and FIG. 4B is a partial three-dimensional cross-sectional view of the power semiconductor device 100 according to the example shown in FIG. 4A along the line A-A'.

Referring to FIG. 3A, the power semiconductor device 100 according to the embodiment can include one or more of a substrate 110, a first conductivity type epitaxial layer 120, a stepped second conductive well 130, a buried insulating layer 150, a first conductivity type source region 140, a gate insulating layer 160, a junction electric field region 122, a second conductivity type ion implantation region 135 (see FIG. 4B), a gate 170, a interlayer insulating layer 180, and/or a source electrode 190.

According to embodiments, the stepped second conductivity type well 130 can include a second conductivity type second-first well 131 and a second conductivity type second-second well 132. The first conductivity type can be N-type, and the second conductivity type can be P-type, but is not limited thereto. Further, the substrate 110 and the first conductivity type epitaxial layer 120 can include silicon carbide (SiC), but is not limited thereto.

Specifically, referring to FIG. 3A, the power semiconductor device 100 according to the embodiment can include a substrate 110, a first conductivity type epitaxial layer 120 disposed on the substrate 110, a stepped second conductivity type well 130 disposed on the first conductivity type epitaxial layer 120 and a source region 140 disposed to be partially spaced apart from a first region of the stepped second conductivity type well 130 and spaced apart from each other, a buried insulating layer 150 disposed in a second region of the second conductivity type well 130 between the source regions 140 and a second conductivity type ion implantation region 135 disposed on one side of the stepped second conductivity type well 130.

In addition, the power semiconductor device 100 according to embodiments can include a gate insulating layer 160 disposed on the stepped second conductivity type well 130 and a gate 170 disposed on the gate insulating layer 160. and an interlayer insulating layer 180 disposed on the gate 170 and a source electrode 190 disposed on the source region 140.

It may be difficult to ion implant into SiC (Silicon Carbide), which may be employed in some embodiments, due to the nature of the material. For example, in order to form a p-well of about 1 µm, ion implantation must be performed with an energy of at least about 650 KeV. Thus, there are technical difficulties in a mass production process for forming wells having a deep depth of 2 µm to 3 µm by ion implantation.

However, one or more of the embodiments described herein can provide power semiconductor devices that address these technical difficulties. According to some embodiments, the second conductivity type second-first well 131 can be formed, and a part of the second conductivity type second-first well 131 can be removed to form a trench structure.

Additionally, the second conductivity type second-second well 132 can be formed by using the ion implantation with the trench structure such that the stepped second conductivity type well 130 can be formed. Therefore, the power semiconductor device according to the embodiment can enhance the SCWT characteristics by the stepped second conductivity type well 130.

Referring to FIG. 3B, the stepped second conductivity type well 130 can include the second conductivity type second-first well 131 having a first width W1 and a second conductivity type second-second well 132 having a third width W3 narrower than the first width W1 and disposed under the second conductivity type second-first well 131.

Also, the buried insulating layer 150 can be disposed in a region of the second conductivity type well 130 between the source regions 140 and can have a second width W2 less than the third width W3 of the second conductivity type second-second well 132.

Therefore, according to the embodiment, since the stepped type second conductivity type well 130 can include the second conductivity type second-first well 131 having a first width W1 and the second conductivity type second-second well 132 having a third width W3 less than the first width W1 and disposed below the second conductivity type second-first well, there is a technical effect that can enhance the SCWT characteristics. In the internal technology, the SCWT of VDMOSFET was about 2.4 *µ*s level, and when this invention according to the embodiment was applied, the SCWT has be significantly improved to about 6.8 *µ*s level.

In particular, since the third width of the second conductivity type second-second well 132 disposed on the lower side can be controlled to be less than that of the second conductivity type second-first well 131 disposed on the upper side, the JFET region can be designed to be further spaced apart in a depth direction of the substrate. So, there is a special technical effect that can improve a loss of the Ron characteristic by preventing the increase of the R_{JFET} by maintaining a high withstand voltage characteristic.

For example, a spacing between a pair of second conductivity type second-second wells 132 (about twice the size of JW2) can be controlled be wider than the spacing between a pair of second conductivity type second-first wells 131(about twice that of JW1). So, there is a special technical effect that can improve the Ron characteristics by preventing the increase of R_{JFET}.

Next, FIG. 4A is a plan view of the power semiconductor device 100 according to embodiments, and FIG. 4B is a partial three-dimensional cross-sectional view taken along line A-A' of the power semiconductor device 100 according to the example shown in FIG. 4A (the buried insulating layer 150 is omitted).

Referring to FIGS. 4A and 4B, the power semiconductor device 100 according to the embodiment can include a substrate 110, a first conductivity type epitaxial layer 120 disposed on the substrate 110, and a stepped second conductivity type well 130 disposed on the epitaxial layer 120, the source region 140 disposed to be partially spaced apart and at a first region of the stepped second conductivity type well 130, a buried insulating layer 150 disposed in the second conductivity type well 130 between the spaced apart source regions 140 and a second conductivity type ion implantation region 135 disposed on one side of the stepped second conductivity type well 130.

Referring to FIG. 4B, the power semiconductor device 100 according to the embodiment can include a source electrode 190 disposed on the source region 140 and the second conductivity type ion implantation region 135. The horizontal width Ws of the contact region 190C of the source electrode can be greater than the horizontal width of the second conductivity type ion implantation region 135, and can be in contact with the source region 140 and the second conductivity type ion implantation region 135.

Referring to FIG. 4B, in an embodiment, the width of the second conductivity type second-second well 132 disposed on the lower side can be controlled to be smaller than the width of the second conductivity type second-first well 131 disposed on the upper side. By designing the JFET area to be further spaced apart in the depth direction of the substrate, there is a special technical effect that can improve the loss of Ron characteristics by maintaining high withstand voltage characteristics and preventing the increase of R_{JFET}.

In addition, according to the embodiment, the stepped second conductivity type well 130 including the second conductivity type second-first well 131 and the second conductivity type second-second well 132 arranged in a narrow width can be deeply formed.

There is a special technical effect that can enhance the SCWT characteristics by controlling second conductivity type second-second well 132 be deeply located. Through this, the embodiment has a special technical effect capable of providing a power semiconductor device, a power semiconductor module, and a power converter which is capable of increasing the robustness by enhancing the short circuit withstand time (SCWT) properties.

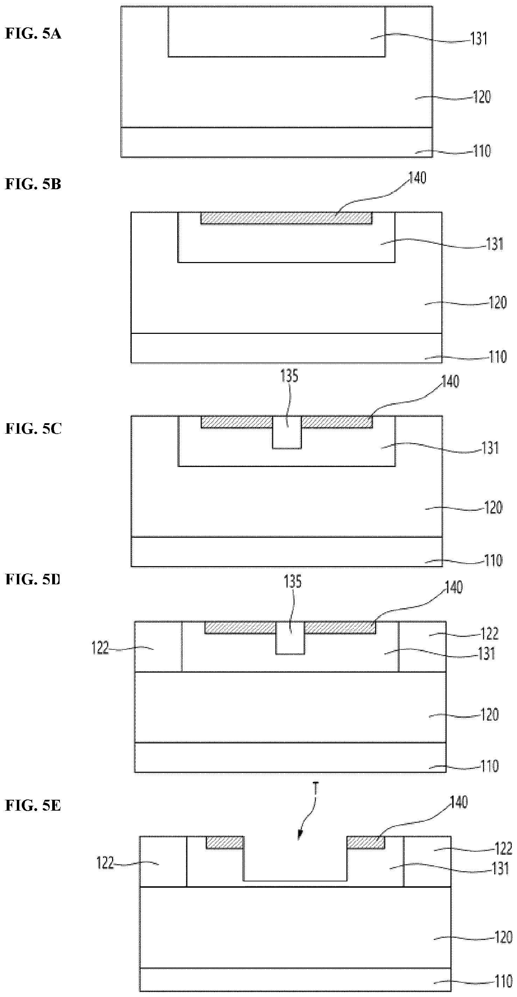

Next, a manufacturing process of a power semiconductor device 100 according to embodiments will be described with reference to FIGS. 5A to 5I.

Referring to FIG. 5A, a substrate 110 including a first conductivity type epitaxial layer 120 can be prepared, and a second conductivity type second-first well 131 can be formed on the first conductivity type epitaxial layer 120.

The substrate 110 and the first conductivity type epitaxial layer 120 can include a 4H-SiC material, but are not limited thereto. For example, the substrate 110 and the first conductivity type epitaxial layer 120 can include 3C-SiC or 6H-SiC. The first conductivity type epitaxial layer 120 can be an N-type drift region, but is not limited thereto.

The second conductivity type second-first well 131 can be ion-implanted with a P-type dopant at a concentration of about 1×10¹⁶ cm⁻³ to about 1×10¹⁹ cm⁻³. For example, Al or boron can be implanted, but is not limited thereto.

Next, referring to FIG. 5B, a first conductivity type source region 140 can be formed in the second conductivity type second-first well 131. For example, the first conductivity type source region 140 can be formed by ion-implanting an N-type dopant such as nitrogen or phosphorus at a concentration of about 1×10¹⁷ cm⁻³ to about 2×10²⁰ cm⁻³.

Next, referring to FIG. 5C, a second conductivity type ion implantation region 135 can be formed. For example, Al or boron can be implanted into the second conductivity type second-first well 131 at a deeper location through the first conductivity type source region 140 to form the second conductivity type ion implantation region 135.

Next, referring to FIG. 5D, a junction electric field regions 122 can be formed on both sides of the second conductivity type ion implantation region 135. The junction field region 122 can be referred to as a JFET region. The junction electric field region 122 can be formed through ion implantation of a P-type dopant such as phosphorus, and characteristics of Vth, saturation current, and on-resistance can be improved.

Referring to FIG. 5E, a trench T can be formed in the second conductivity type second-first well 131. For example, a trench T can be formed to remove portions of the source region 140, the second conductivity type ion implantation region 135, and the second conductivity type second-first well 131 by etching. The first conductivity type epitaxial layer 120 cannot be exposed by the trench T.

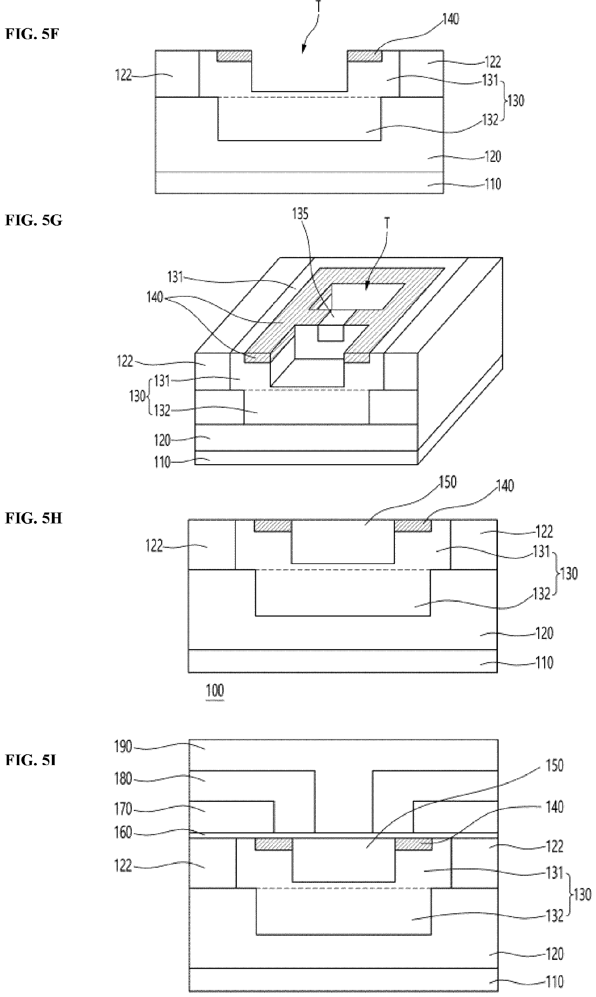

Next, referring to FIGS. 5F and 5G (FIG. 5G is a three-dimensional cross-sectional view of FIG. 5F), the second conductivity type second-second well 132 can be formed on a bottom and sidewalls of the trench T through an ion implantation process to form a step difference such that the type second conductivity type well 130 can be manufactured.

For example, by forming the second conductivity type second-second well 132 through ion implantation on the sidewall and bottom of the trench T of the second conductivity type second-first well 131, the stepped second conductivity type Well 130 can be formed. For example, the second conductivity type second-second well 132 can be formed through an activation process after performing ion implantation four times with tilt and rotation of 90° on each four side surfaces respectively and one ion implantation on the bottom surface.

In addition, according to the embodiment, since the width of the second conductivity type second-second well 132 is controlled to be smaller than that of the second conductivity type second-first well 131, there is a special technical effect that can improve the loss of Ron characteristics by preventing an increase of R_{JFET} by maintaining high withstand voltage characteristics by controlling JFET region to be further spaced apart in the depth direction of the substrate.

Next, referring to FIG. 5H, a buried insulating layer 150 can be formed in the second conductive type well 130 between the source regions 140 separated by the trench. The buried insulating layer 150 can be formed of oxide or nitride.

Next, referring to FIG. 5I, a gate insulating layer 160 can be formed on the stepped second conductivity type well 130, a gate 170 can be formed on the gate insulating layer 160. And an interlayer insulating layer 180 can be formed on the gate 170, and a source electrode 190 can be formed on the source region 140 after partially opening the interlayer insulating layer 180.

The gate insulating layer 160 can be a thermal oxide layer or a deposition oxide layer, but is not limited thereto. The gate 170 can be formed of polysilicon, but is not limited thereto. The interlayer insulating layer 180 can be formed of an oxide film or a nitride film, but is not limited thereto. The source electrode 190 can be formed of Al or the like, but is not limited thereto.

According to the power semiconductor device, the power semiconductor module, and the power converter including the same of the embodiment, there are technical effects of improving SCWT characteristics while minimizing Ron increase by the stepped second conductivity type well 130 designed to be deeply located.

The design and manufacture of power semiconductor devices can introduce competing, and often contradictory, challenges for optimal performance.

For instance, MOSFET devices for power semiconductors with a high-power switching function can have a higher robustness as SCWT (Short Circuit Withstand Time) increases as explained above.

However, a SiC VDMOSFET (for example) that employs a shallow P-well structure for ease manufacturing within the line where withstand voltage can be secured may see the robustness of the power semiconductor device weakened due to a shortening of the SCWT.

One of the technical objects of embodiments described herein is to provide a power semiconductor device and a power converter including the same that addresses this issue. One approach to solving the issue is by a stepped second conductivity type well designed to be deeply located.

According to some embodiments, a stepped second conductivity type well 130 can include a second conductivity type second-first well 131 disposed on an upper side and a second conductivity type second-second well 132 disposed on a lower side. In this case, a width of the second conductivity type second-second well 132 disposed on the lower side can be controlled to be smaller than that of the second conductivity type second-first well 131 disposed on the upper side. Accordingly, the JFET region can be designed to be further spaced apart in a depth direction of the substrate. Therefore, there is a special technical effect that can improve a loss of the Ron characteristic by preventing the increase of the R_{JFET} by maintaining a high withstand voltage characteristic.

According to some embodiments, a power semiconductor device can include a substrate, a first conductivity type epitaxial layer disposed on the substrate, a stepped second conductivity type well disposed on the first conductivity type epitaxial layer, a source region partially spaced apart from a first region of the stepped second conductivity type well, a buried insulating layer disposed in a second region of the second conductive type well between the spaced apart source regions, a gate insulating layer disposed on the stepped second conductivity type well, a gate disposed on the gate insulating layer, an interlayer insulating layer disposed on the gate and a source electrode disposed on the source region.

In certain aspects, the stepped second conductivity type well can include a second conductivity type second-first well having a first width, and a second conductivity type second-second well having a third width narrower than the first width and disposed under the second conductivity type second-first well.

The buried insulating layer can be disposed in a region of the second conductivity type well between the spaced apart source regions.

A horizontal width of the buried insulating layer can be a second width smaller than the third width of the second conductivity type second-second well.

A doping concentration of the second conductivity type second-second well can be equal or less than that of the second conductivity type second-first well.

Further, the power semiconductor device according to embodiments can include a second conductivity type ion implantation region disposed on one side of the stepped second conductivity type well.

A horizontal width of a contact region of the source electrode can be greater than that of the second conductivity type ion implantation region.

The contact area of the source electrode can be contact with the source region and the second conductivity type ion implantation region.

A power converter according to the embodiment can include at least one of the power semiconductor devices as above.

In addition, according to the embodiment, the stepped second conductivity type well 130 can include the second conductivity type second-first well 131 and the second conductivity type second-second well 132 disposed there below with a narrow width, there is a special technical effect that can enhance the SCWT characteristics by designing the second conductivity type second-second well 132 to be deeply located.

While various aspects are described herein, it should be understood that they have been presented by way of example only, and not limitation. Thus, the breadth and scope of this disclosure should not be limited by any of the above-described exemplary aspects. Moreover, any combination of the above-described elements in all possible variations thereof is encompassed by the disclosure unless otherwise indicated herein or otherwise clearly contradicted by context.

Additionally, while the processes described above as a sequence of steps, this was done solely for the sake of description. Accordingly, it is contemplated that some steps may be added, some steps may be omitted, the order of the steps may be re-arranged, and some steps may be performed in parallel.

## Claims

1. A power semiconductor device (100), comprising:
a substrate (110); and
a stepped well (130), wherein the stepped well (130) comprises a first region, a second region, and an insulating layer (150) in the first region.

2. The device of claim 1, wherein the first region has a width W1, the second region has a width W3, and the width W1 is greater than the width W3.

3. The device of claim 2, wherein the second region is located below the first region.

4. The device of claim 2 or 3, wherein the insulating layer (150) is a buried insulating layer having a width W2, and the width W3 is greater than the width W2.

5. The device of any one of the preceding claims, further comprising a source region (140), wherein the source region (140) comprises a first portion and a second portion, and wherein the first and second portions of the source region (140) are separated by the insulating layer (150).

6. The device of claim 5, wherein:
(i) at least the second region of the stepped well (130) is formed in a first conductivity type epitaxial layer (120) on the substrate (110),
(ii) both the first and second regions of the stepped well (130) have a second conductivity type, and
(iii) the source region (140) has the first conductivity type.

7. The device of claim 6, wherein at least one of the substrate (110) or the epitaxial layer (120) comprise silicon carbide (SiC).

8. The device of any one of the preceding claims, wherein a doping concentration of the second region of the stepped well (130) is less than or equal to the doping concentration of the first region of the stepped well (130).

9. The device of any one of the preceding claims, further comprising:
a gate insulating layer (160) disposed on the stepped well (130);
a gate (170) disposed on the gate insulating layer (160);
an interlayer insulating layer (180) disposed on the gate (170); and
a source electrode (190) disposed on a source region (140) of the device.

10. The device of claim 9, further comprising:
an ion implantation region (135) disposed on at least one side of the stepped well (130),
wherein a width of a contact region of the source electrode (190) is greater than a width of the ion implantation region (135), and
wherein a contact area of the source electrode (190) is in contact with the source region (140) and the ion implantation region (135).

11. The device of any one of the preceding claims, comprising a plurality of stepped wells (130), wherein a first of the plurality of stepped wells (130) is separated from a second of the plurality of stepped wells (130) by an ion implantation region (135).

12. A power converter (1000) comprising at least one power semiconductor device (100) according to any one of claims 1 to 11.

13. A method for manufacturing a semiconductor device, comprising:
forming, on a substrate (110), a first epitaxial layer (120) and a first well (131), wherein the first epitaxial layer (120) has a first conductivity type and the first well (131) has a second conductivity type;
forming a source region (140) in the first well (131), wherein the source region (140) has the first conductivity type;
forming an ion implantation region (135) in the first well (131) and through the source region (140), wherein the ion implantation region (135) has the second conductivity type and extends deeper into the first well (131) than the source region (140);
forming one or more junction field effect (JFET) regions (122) on either side of the ion implantation region (135) ;
forming a trench (T) in the first well (131); and
forming a stepped-well structure comprising the first well (131) and a second well (132) below the first well (131).

14. The method of claim 13, further comprising applying an insulating layer (150) in the trench (T).

15. The method of claim 13, wherein forming the stepped-well structure comprises performing an ion implantation on a bottom of the trench (T) to generate the second well (132).
